# EUROPEAN PATENT APPLICATION

(11) **EP 4 641 219 A1**
(43) Date of publication of application: **29.10.2025**
(21) Application number: 23906781.2
(22) Date of filing: 08.12.2023
(51) Int. Cl.: G01R 15/18, G01R 15/20

(54) **ZERO FLUX TYPE CURRENT SENSOR, AND MEASURING DEVICE**

(30) Priority: 19.12.2022 JP 2022202523; 21.11.2023 JP 2023197583
(71) Applicant: Hioki E.E. Corporation, Ueda-shi, Nagano 386-1192 (JP)
(72) Inventor: XIA, Peiyu, Ueda-shi, Nagano 386-1192 (JP); IKEDA, Kenta, Ueda-shi, Nagano 386-1192 (JP); NAKAZAWA, Koki, Ueda-shi, Nagano 386-1192 (JP); KARASAWA, Yuki, Ueda-shi, Nagano 386-1192 (JP)
(74) Representative: Reddie & Grose LLP
(86) International application number: PCT/JP2023/044064
(87) International publication number: WO 2024/135415

(57) **Abstract**

A current sensor includes a magnetic detection element configured to detect a magnetic flux generated in a magnetic core, a feedback circuit configured to output, based on a signal input from the magnetic detection element, a negative feedback current for canceling out the magnetic flux generated in the magnetic core. The current sensor includes a winding wound around the magnetic core and configured to receive the negative feedback current from one end, detect a magnetic flux flowing through the magnetic core, and output a detection current indicating a measurement current from the other end. The current sensor includes a plurality of connection circuits configured to block components from a direct current to a low frequency band, and a plurality of resistors connected in parallel to a plurality of winding sections that constitute the winding and are connected in series. Each of the plurality of connection circuits is connected between a connection point between adjacent resistors among the plurality of resistors and a connection point between adjacent winding sections, and between an output end of the feedback circuit and a resistor connected to the output end.

## Description

### TECHNICAL FIELD

The present invention relates to a current sensor of a zero flux type and a measurement device.

### BACKGROUND ART

JP2014-235045A discloses a current sensor (hereinafter, referred to as a current sensor 1) of a zero flux type that can detect a current from a direct current to a high frequency band.

The current sensor 1 includes a magnetic detection element and a feedback circuit that negatively feeds back an output signal of the magnetic detection element to a winding. Accordingly, the current sensor 1 can detect a current from a direct current to a predetermined high frequency band.

Further, US3146417A discloses a current sensor (hereinafter, referred to as a current sensor 2) that detects a current flowing through a measurement object.

In the current sensor 2, a winding wound around a magnetic core includes a plurality of winding sections connected in series. The current sensor 2 has resistors, each of which serves as a current detection resistor and a damping resistor and has a resistance value of several Ω to several tens of Ω, connected in parallel to respective winding sections, and can detect a current up to a high frequency band higher than that of the current sensor 1.

### SUMMARY OF INVENTION

The current sensor 2 cannot detect a direct current in principle, but can detect a current up to a high frequency band higher than that of the current sensor 1.

Therefore, a configuration is conceivable in which the current sensor 2 is combined with the current sensor 1, and a negative feedback current generated based on the output signal of the magnetic detection element is fed back to the winding to enable detection of a current from a direct current to a frequency band higher than the predetermined high frequency band.

However, in the current sensor having such a configuration, in a frequency band in which an impedance of the resistor connected in parallel to each winding section is smaller than an impedance of each winding section, the negative feedback current flows through the resistor connected in parallel to each winding section, and a negative feedback operation cannot be performed.

The present invention has been made in view of the above problems, and an object of the present invention is to enable detection of a current from a direct current to a frequency band higher than a predetermined high frequency band by performing a negative feedback operation.

A current sensor according to an aspect of the present invention is a current sensor of a zero flux type. The current sensor includes a magnetic core configured to surround a measurement object through which a measurement current flows, and a magnetic detection element incorporated in the magnetic core and configured to detect a magnetic flux generated in the magnetic core. The current sensor includes a feedback circuit configured to output, based on a signal input from the magnetic detection element, a negative feedback current for canceling out the magnetic flux generated in the magnetic core by the measurement current. The current sensor includes a winding wound around the magnetic core and configured to receive the negative feedback current from one end, detect a magnetic flux flowing through the magnetic core, and output from the other end a detection current indicating the measurement current. The current sensor includes a plurality of connection circuits configured to block components from a direct current to a low frequency band, and a plurality of resistors connected in parallel to a plurality of winding sections that constitute the winding and are connected in series. Each of the plurality of connection circuits is connected between a connection point between adjacent resistors among the plurality of resistors and a connection point between adjacent winding sections, and between an output end of the feedback circuit and a resistor connected to the output end.

In this aspect, the resistors are connected in parallel to the winding sections constituting the winding via the connection circuits that block the components from the direct current to the low frequency band. For this reason, the negative feedback current input from the one end of the winding does not flow to the resistors in a frequency band from a direct current to a low frequency band. Accordingly, the current sensor can suppress a decrease in detection accuracy of a current from a direct current to a low frequency band without impairing a normal negative feedback operation, and can detect a current from a direct current to a frequency band higher than the predetermined high frequency band.

### BRIEF DESCRIPTION OF DRAWINGS

[FIG. 1] FIG. 1 is a schematic view illustrating a measurement device including a current sensor according to a first embodiment.
[FIG. 2] FIG. 2 illustrates an equivalent circuit of the current sensor according to the first embodiment.
[FIG. 3] FIG. 3 is a schematic view illustrating a modification of the measurement device according to the first embodiment.
[FIG. 4] FIG. 4 is a schematic view illustrating a measurement device including a current sensor according to a second embodiment.
[FIG. 5] FIG. 5 illustrates an equivalent circuit of the current sensor according to the second embodiment.
[FIG. 6] FIG. 6 is a schematic view illustrating a measurement device including a current sensor according to a third embodiment.
[FIG. 7] FIG. 7 illustrates an equivalent circuit of the current sensor according to the third embodiment.
[FIG. 8] FIG. 8 illustrates a part of an equivalent circuit of a current sensor according to a fourth embodiment.
[FIG. 9] FIG. 9 illustrates a connection circuit according to the fourth embodiment.
[FIG. 10] FIG. 10 is a diagram illustrating a relationship between frequency and impedance in the connection circuit according to the fourth embodiment.

### DESCRIPTION OF EMBODIMENTS

Hereinafter, embodiments of the present invention will be described with reference to the accompanying drawings. In this specification, the same or equivalent elements are denoted by the same reference numerals throughout the specification.

### <First Embodiment>

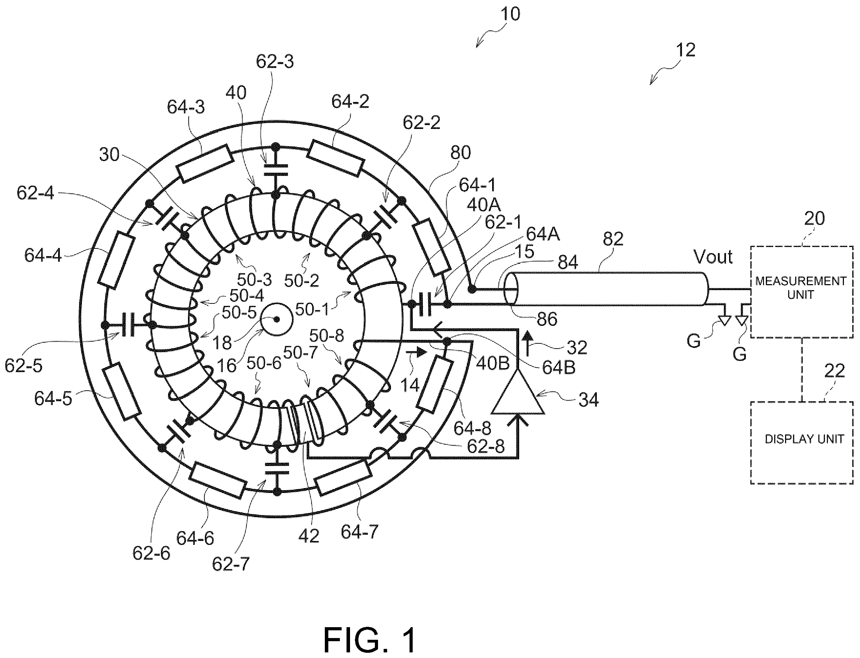

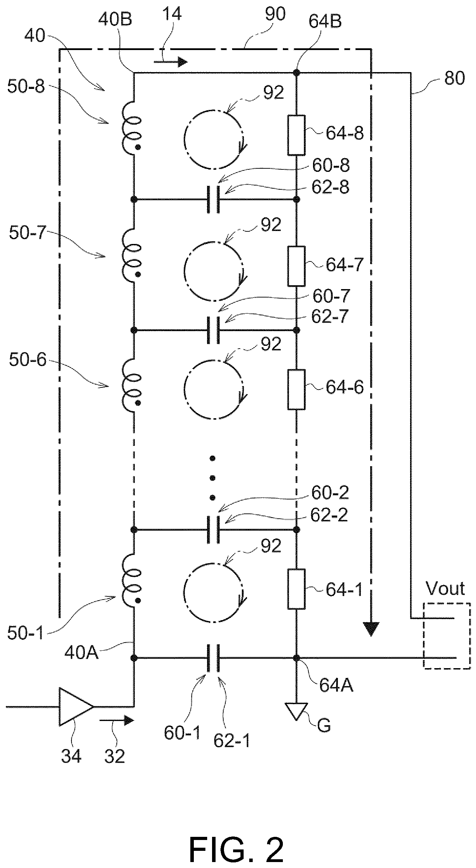

A measurement device 12 including a current sensor 10 according to a first embodiment will be described with reference to FIGS. 1 and 2. FIG. 1 is a schematic view illustrating the measurement device 12 including the current sensor 10 according to the first embodiment. FIG. 2 illustrates an equivalent circuit of the current sensor 10 according to the first embodiment.

As illustrated in FIG. 1, the measurement device 12 includes the current sensor 10 of the zero flux type and a measurement unit 20 that measures a measurement current 18 flowing through a measurement object 16 based on a detection current 14 output from the current sensor 10. Further, in the first embodiment, the measurement device 12 includes a display unit 22 that displays the measurement current 18 measured by the measurement unit 20.

The measurement unit 20 includes, for example, a processor including a CPU. The measurement unit 20 performs arithmetic processing on a voltage (hereinafter, referred to as a voltage 15) at an end 15 of a return line 80 corresponding to the detection current 14 input from the current sensor 10 by the processor to acquire measurement data indicating the measurement current 18, and outputs the acquired measurement data to the display unit 22. The display unit 22 includes, for example, a liquid crystal display, and visually displays the measurement data input from the measurement unit 20 as the measurement current 18.

The current sensor 10 includes an annular magnetic core 30 provided with a gap for sandwiching a magnetic detection element 42, and a feedback circuit 34 that outputs a negative feedback current 32 for canceling out a magnetic flux generated in the magnetic core 30 by the measurement current 18. Further, the current sensor 10 includes a winding 40 that is wound around the magnetic core 30, receives the negative feedback current 32 from one end 40A, detects a magnetic flux flowing through the magnetic core 30, and outputs from the other end 40B the detection current 14 indicating the measurement current 18.

### (Magnetic Core)

The magnetic core 30 is formed of a magnetic material in an annular shape. The measurement object 16 through which the measurement current 18 flows is disposed inside the magnetic core 30. Accordingly, during measurement, the magnetic core 30 surrounds the measurement object 16 through which the measurement current 18 flows.

Here, the magnetic core 30 surrounding the measurement object 16 through which the measurement current 18 flows means that the magnetic core 30 surrounds the measurement object 16 during measurement. The current sensor 10 of the first embodiment does not define a configuration in which the magnetic core 30 always surrounds the measurement object 16.

A magnetic detection element 42 is incorporated in the magnetic core 30. Examples of a structure in which the magnetic detection element 42 is incorporated into the magnetic core 30 include a structure in which the magnetic detection element 42 is disposed in the gap of the magnetic core 30 and a structure in which the magnetic detection element 42 is disposed in parallel with the magnetic core 30. In the first embodiment, a case where the magnetic detection element 42 is disposed in the gap formed in an intermediate portion of the magnetic core 30 will be described as an example.

The magnetic detection element 42 detects a magnetic flux generated in the magnetic core 30 by the measurement current 18 flowing through the measurement object 16. The magnetic detection element 42 outputs a signal based on the detected magnetic flux to the feedback circuit 34.

Examples of the magnetic detection element 42 include a flux gate and a Hall element. In the first embodiment, the magnetic detection element 42 is composed of a Hall element.

### (Feedback Circuit)

The feedback circuit 34 generates the negative feedback current 32 based on the signal output from the magnetic detection element 42, and outputs the generated negative feedback current 32 from an output end to the one end 40A of the winding 40. The negative feedback current 32 is mainly composed of a current having a frequency from a direct current to a high frequency band. The winding 40 to which the negative feedback current 32 is input generates a magnetic flux in the magnetic core 30. The magnetic flux from the winding 40 acts to cancel out the magnetic flux generated in the magnetic core 30 by the measurement current 18.

### (Winding)

The winding 40 is composed of a conductive wire. The winding 40 is wound in a poloidal direction along a toroidal direction with respect to the magnetic core 30. The winding 40 is wound over substantially an entire circumference of the magnetic core 30 in the toroidal direction. The winding 40 detects the magnetic flux flowing through the magnetic core 30 and outputs from the other end 40B the detection current 14 indicating the measurement current 18. The detection current 14 detected by the winding 40 is mainly composed of a high frequency signal.

The winding 40 includes a plurality of winding sections 50-1 to 50-8 connected in series. An inductance of each of the winding sections 50-1 to 50-8 is set in a range of, for example, 1 nH or more and 10 H or less. Resistors 64-1 to 64-8 are connected in parallel to the winding sections 50-1 to 50-8 via connection circuits 62-1 to 62-8 including capacitors 60-1 to 60-8 (see FIG. 2).

The winding 40 of the first embodiment is divided into eight parts by a first connection circuit 62-1 connected to the one end 40A of the winding 40 and connection circuits 62-2 to 62-8 connected to positions shifted in the toroidal direction of the winding 40.

Specifically, the first connection circuit 62-1 is connected to the one end 40A of the winding 40. A second connection circuit 62-2, a third connection circuit 62-3, a fourth connection circuit 62-4, a fifth connection circuit 62-5, a sixth connection circuit 62-6, a seventh connection circuit 62-7, and an eighth connection circuit 62-8 are connected to an intermediate portion of the winding 40. The first connection circuit 62-1 to the eighth connection circuit 62-8 are arranged in order from the one end 40A to the other end 40B of the winding 40.

In the winding 40, a first winding section 50-1 is formed between a connection position of the first connection circuit 62-1 and a connection position of the second connection circuit 62-2, and a second winding section 50-2 is formed between the connection position of the second connection circuit 62-2 and a connection position of the third connection circuit 62-3. In the winding 40, a third winding section 50-3 is formed between the connection position of the third connection circuit 62-3 and a connection position of the fourth connection circuit 62-4, and a fourth winding section 50-4 is formed between the connection position of the fourth connection circuit 62-4 and a connection position of the fifth connection circuit 62-5.

In the winding 40, a fifth winding section 50-5 is formed between the connection position of the fifth connection circuit 62-5 and a connection position of the sixth connection circuit 62-6, and a sixth winding section 50-6 is formed between the connection position of the sixth connection circuit 62-6 and a connection position of the seventh connection circuit 62-7. In the winding 40, a seventh winding section 50-7 is formed between the connection position of the seventh connection circuit 62-7 and a connection position of the eighth connection circuit 62-8, and an eighth winding section 50-8 is formed between the connection position of the eighth connection circuit 62-8 and the other end 40B.

As illustrated in FIG. 2, the connection circuits 62-1 to 62-8 include the capacitors 60-1 to 60-8. The capacitors 60-1 to 60-8 desirably have the same capacitance value. The capacitance value of each of the capacitors 60-1 to 60-8 is set in a range of, for example, 100 pF or more and 10 pF or less.

### (Resistor)

A resistance value of each of the resistors 64-1 to 64-8 is set in a range of, for example, 1 Ω to 100 Ω.

Each of the resistors 64-1 to 64-8 functions as a damping resistor that suppresses a resonance caused by each of the winding sections 50-1 to 50-8.

The resistors 64-1 to 64-8 are connected in series. One end 64A of the resistors 64-1 to 64-8 connected in series is connected to the one end 40A of the winding 40 via the first connection circuit 62-1. The other end 64B of the resistors 64-1 to 64-8 connected in series is directly connected to the other end 40B of the winding 40.

At both ends of the resistors 64-1 to 64-8, a voltage generated in each of the winding sections 50-1 to 50-8 according to a magnitude of the measurement current 18 appears. For this reason, the voltage corresponding to the measurement current 18 is obtained by summing the voltages of the resistors 64-1 to 64-8 connected in series.

A potential difference generated between the one end 64A and the other end 64B of the resistors 64-1 to 64-8 connected in series indicates the voltage 15 corresponding to the detection current 14 (see FIG. 1). For this reason, each of the resistors 64-1 to 64-8 also functions as a shunt resistor serving as a current detection resistor that converts a current flowing through each of the resistors 64-1 to 64-8 into a voltage.

### (Return Line)

As illustrated in FIG. 1, the return line 80 extends from the other end 40B of the winding 40. The return line 80 extends along the magnetic core 30 from the other end 40B toward the one end 40A of the winding 40.

The winding 40 is wound substantially once around the magnetic core 30 in the toroidal direction to form a one-turn coil. For this reason, the winding 40 acts as a loop antenna, and can also detect an external magnetic field other than a magnetic field generated by the measurement current 18.

On the other hand, the return line 80 forms a one-turn coil folded back at the other end 40B of the winding 40, and cancels out a current caused by the external magnetic field detected by the one-turn coil composed of the winding 40 by a current corresponding to the external magnetic field to suppress an influence of the external magnetic field.

The return line 80 is connected to an inner conductor 84 constituting a coaxial cable 82. The one end 64A of the resistors 64-1 to 64-8 connected in series is connected to the outer conductor 86 constituting a shield portion of the coaxial cable 82 and a reference potential G.

The inner conductor 84 of the coaxial cable 82 is connected to the measurement unit 20. The outer conductor 86 is connected to the measurement unit 20 via the reference potential G. In the measurement unit 20, the measurement current 18 is measured based on the voltage 15 corresponding to the detection current 14 output from the current sensor 10. The measurement current 18 measured by the measurement unit 20 is displayed on the display unit 22.

### (Operation in Low Frequency Band)

As illustrated in FIG. 2, in the current sensor 10, the connection circuits 62-1 to 62-8 are provided between the winding sections 50-1 to 50-8 and the resistors 64-1 to 64-8.

Each of the capacitors 60-1 to 60-8 constituting the connection circuits 62-1 to 62-8 has a high impedance with respect to the negative feedback current 32 from the direct current to the low frequency band input from the one end 40A of the winding 40. Specifically, the capacitors 60-1 to 60-8 each have a higher impedance than the corresponding resistors 64-1 to 64-8.

For this reason, the negative feedback current 32 from the direct current to the low frequency band is blocked from flowing to the resistors 64-1 to 64-8, and the negative feedback current 32, which flows through a current path 90 and ranges from the direct current to the low frequency band, flows through all the winding sections 50-1 to 50-8. The negative feedback current 32 flowing through the winding sections 50-1 to 50-8 flows through the resistors 64-1 to 64-8 connected in series.

Accordingly, by measuring a potential difference between the other end 64B of the resistors 64-1 to 64-8 connected in series and the reference potential G, the voltage 15 corresponding to the negative feedback current 32 output based on the measurement current 18 can be acquired.

### (Operation in High Frequency Band)

In the high frequency band, since the signal output from the magnetic detection element 42 is extremely small, a negative feedback operation does not occur, and each of the winding sections 50-1 to 50-8 operates as a current transformer (CT). The capacitors 60-1 to 60-8 included in the connection circuits 62-1 to 62-8 each have a low impedance with respect to a loop current 92 (see FIG. 2). Specifically, the capacitors 60-1 to 60-8 each have a lower impedance than the corresponding resistors 64-1 to 64-8. For this reason, the loop current 92 generated in each of the winding sections 50-1 to 50-8 according to the measurement current 18 flows through the capacitors 60-1 to 60-8 constituting the connection circuits 62-1 to 62-8 and the corresponding resistors 64-1 to 64-8. A voltage corresponding to the current flowing through each of the capacitors 60-1 to 60-8 and the corresponding resistors 64-1 to 64-8 appears at both ends of the resistors 64-1 to 64-8.

For this reason, the current generated in the winding 40 according to the measurement current 18 can be acquired from both ends of the resistors 64-1 to 64-8 connected in series.

In this way, the current sensor 10 of the first embodiment can detect a current in a wide band from a direct current to a high frequency band.

It is desirable that the capacitors 60-1 to 60-8 constituting the connection circuits 62-1 to 62-8 each have a capacitance value such that the impedance thereof becomes sufficiently higher (for example, 10 times or more) than the impedance of each of the resistors 64-1 to 64-8 in the frequency band from the direct current to the low frequency band (for example, several kHz). In addition, in a band in which the resonance occurs in the winding sections 50-1 to 50-8, it is desirable to set the capacitance value such that the impedance of each of the capacitors 60-1 to 60-8 constituting the connection circuits 62-1 to 62-8 is sufficiently lower (for example, 1/10 or less) than the impedance of each of the resistors 64-1 to 64-8. Examples of the band in which the resonance caused by a line capacitance (stray capacitance) occurs in the winding sections 50-1 to 50-8 include a band of 100 kHz or more.

As an example, when the impedance of each of the resistors 64-1 to 64-8 is 10 Ω, the capacitance value of each of the capacitors 60-1 to 60-8 included in the connection circuits 62-1 to 62-8 is 100 nF. Accordingly, the impedance of each of the capacitors 60-1 to 60-8 included in the connection circuits 62-1 to 62-8 is, for example, 1.6 kΩ at 1 kHz and 16 Ω at 100 kHz.

### (Functions and Effects)

Next, functions and effects of the first embodiment will be described.

The current sensor 10 according to the first embodiment is the current sensor 10 of the zero flux type. The current sensor 10 includes the magnetic core 30 surrounding the measurement object 16 through which the measurement current 18 flows, and the magnetic detection element 42 incorporated in the magnetic core 30 and configured to detect a magnetic flux generated in the magnetic core 30. The current sensor 10 includes the feedback circuit 34 that outputs the negative feedback current 32 for canceling out the magnetic flux generated in the magnetic core 30 by the measurement current 18 based on the signal input from the magnetic detection element 42. The current sensor 10 includes the winding 40 that is wound around the magnetic core 30, receives the negative feedback current 32 from the one end 40A, detects the magnetic flux flowing through the magnetic core 30, and outputs from the other end 40B the detection current 14 indicating the measurement current 18. The current sensor 10 includes the connection circuits 62-1 to 62-8 that block components from the direct current to the low frequency band, and the resistors 64-1 to 64-8 connected in parallel to the winding sections 50-1 to 50-8 that constitute the winding 40 and are connected in series. Each of the connection circuits 62-1 to 62-8 is connected between a connection point between adjacent resistors of the resistors 64-1 to 64-8 and a connection point between adjacent winding sections of the winding sections 50-1 to 50-8, and between an output end of the feedback circuit 34 and the resistor (64-1) connected to the output end (via the first connection circuit 62-1).

In this configuration, the resistors 64-1 to 64-8 are connected in parallel to the winding sections 50-1 to 50-8 constituting the winding 40 via the connection circuits 62-1 to 62-8 composed of the capacitors 60-1 to 60-8. For this reason, in the frequency band from the direct current to the low frequency band, the negative feedback current 32 input from the one end 40A of the winding 40 is blocked by the capacitors 60-1 to 60-8 of the connection circuits 62-1 to 62-8 and does not flow to the resistors 64-1 to 64-8.

In this way, the resistors 64-1 to 64-8 are connected in parallel to the winding sections 50-1 to 50-8 constituting the winding 40 via the connection circuits 62-1 to 62-8 that block the components from the direct current to the low frequency band. For this reason, in the current sensor 10, a normal negative feedback operation is not impaired from the direct current to the low frequency band, a decrease in detection accuracy of the current from the direct current to the low frequency band is suppressed, and the current up to the frequency band higher than the predetermined high frequency band can be detected.

The measurement device 12 according to the first embodiment includes the current sensor 10 described above and the measurement unit 20 that measures the measurement current 18 based on the detection current 14 output from the current sensor 10.

For this reason, as described above, the normal negative feedback operation is not impaired from the direct current to the low frequency band, the decrease in detection accuracy of the current from the direct current to the low frequency band is suppressed, and the current up to the frequency band higher than the predetermined high frequency band can be measured.

The measurement current 18 measured by the measurement unit 20 can be displayed visually by, for example, the display unit 22.

The current sensor 10 of the first embodiment further includes the return line 80 extending from the other end 40B of the winding 40 and disposed along the magnetic core 30 from the other end 40B toward the one end 40A of the winding 40.

For this reason, even when the external magnetic field is detected by a loop formed by the winding 40 along the magnetic core 30, the current generated by the external magnetic field can be canceled out by the current generated by the external magnetic field detected by a loop formed by the return line 80. Accordingly, the influence of the external magnetic field can be suppressed.

In particular, the current caused by the external magnetic field detected by the loop formed by the winding 40 becomes prominent at a higher frequency band in the high frequency band. However, in the first embodiment, since the influence of the external magnetic field can be suppressed, the characteristics at the higher frequency band in the high frequency band are improved.

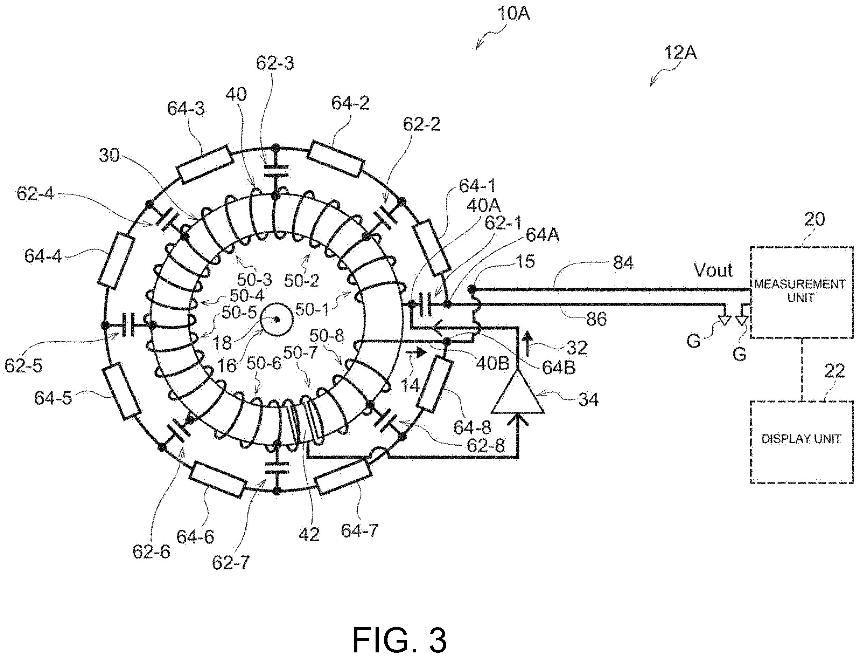

In the first embodiment, the case where the current sensor 10 is configured by disposing the return line 80 has been described, but the configuration of the first embodiment is not limited thereto, and the return line 80 may be removed. Therefore, a configuration example in which the return line 80 is removed will be briefly described with reference to FIG. 3.

### (First Modification of First Embodiment)

FIG. 3 is a schematic view illustrating a first modification of the measurement device 12 according to the first embodiment.

In a measurement device 12A of the first modification, the return line 80 and the coaxial cable 82 are removed from the configuration of the current sensor 10 illustrated in FIG. 1. For this reason, in the current sensor 10A, the one end 64A of the resistors 64-1 to 64-8 connected in series is connected to the reference potential G, and the other end 64B of the resistors 64-1 to 64-8 connected in series is connected to an input terminal of the measurement unit 20. Since other configurations are the same as or equivalent to those of the measurement device 12 illustrated in FIG. 1, the same reference numerals are given and descriptions thereof will be omitted here.

### (Functions and Effects)

With this configuration, similar to the configuration of the current sensor 10 illustrated in FIG. 1, the resistors 64-1 to 64-8 are connected in parallel to the winding sections 50-1 to 50-8 constituting the winding 40 via the connection circuits 62-1 to 62-8 that block components from a direct current to a low frequency band. For this reason, in the current sensor 10A, a normal negative feedback operation is not impaired from the direct current to the low frequency band, a decrease in detection accuracy of the current from the direct current to the low frequency band is suppressed, and the current up to the frequency band higher than the predetermined high frequency band can be detected.

In the measurement device 12A, the same configuration as that of the measurement device 12 illustrated in FIG. 1 can achieve the same functions and effects as those of the first embodiment described above.

Further, in the first embodiment, the case where the connection circuits 62-1 to 62-8 include only the capacitors 60-1 to 60-8 has been described, but the configuration of the first embodiment is not limited thereto.

### (Second Modification of First Embodiment)

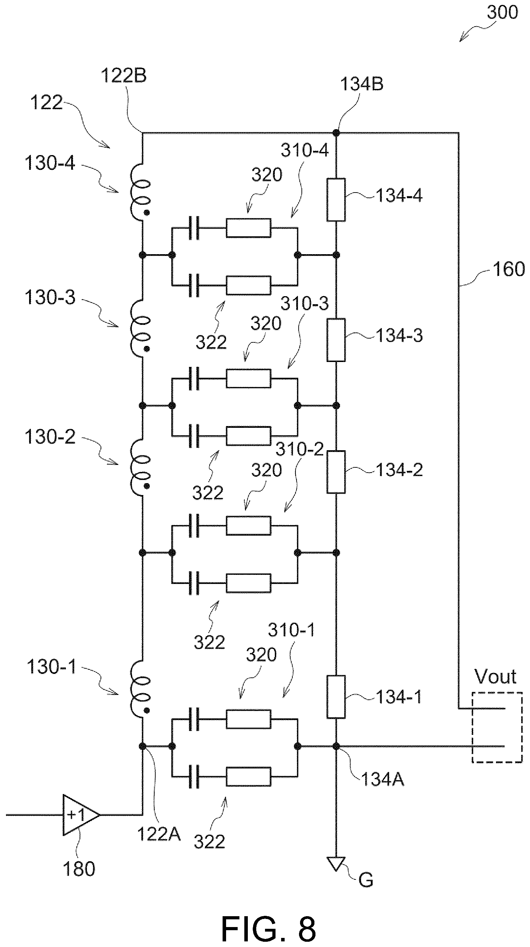

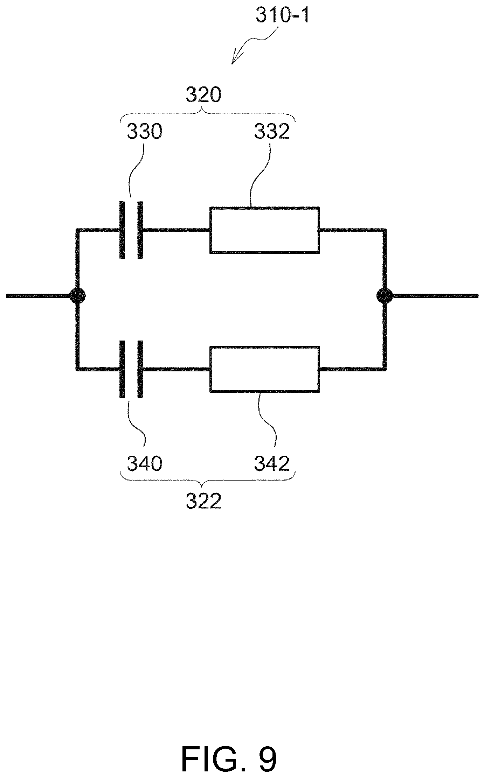

As illustrated in FIGS. 8 and 9 (particularly, FIG. 9), each of the connection circuits 62-1 to 62-8 (see FIG. 2) may include capacitors (330, 340) and resistors (332, 342), which are connected in series.

### (Functions and Effects)

With this configuration, in each of the connection circuits 62-1 to 62-8, the resonance occurring at a resonance frequency corresponding to capacitance values of the capacitors (330, 340) can be attenuated by the resistors (332, 342) connected in series with the capacitors (330, 340).

Accordingly, compared to a current sensor that cannot suppress the resonance, the current sensor 10 of the first embodiment has improved flatness in frequency characteristics.

### (Third Modification of First Embodiment)

As illustrated in FIGS. 8 and 9 (particularly, FIG. 9), each of the connection circuits 62-1 to 62-8 (see FIG. 2) may be composed of a parallel connection circuit including a first circuit (320) in which a first capacitor (330) and a first resistor (332) are connected in series and a second circuit (322) in which a second capacitor (340) and a second resistor (342) are connected in series. In this example, the first capacitor (330) and the second capacitor (340) are set to different capacitance values.

### (Functions and Effects)

With this configuration, a frequency at which the resonance is attenuated in the first circuit (320) can be made different from a frequency at which the resonance is attenuated in the second circuit (322). Accordingly, the current sensor 10 can suppress the resonance in a plurality of frequency bands within a measurement range by adjusting the capacitance values of the first capacitor (330) and the second capacitor (340).

Further, the current sensor 10 can suppress the resonance occurring at a target frequency by adjusting the capacitance values of the first capacitor (330) and the second capacitor (340).

### <Second Embodiment>

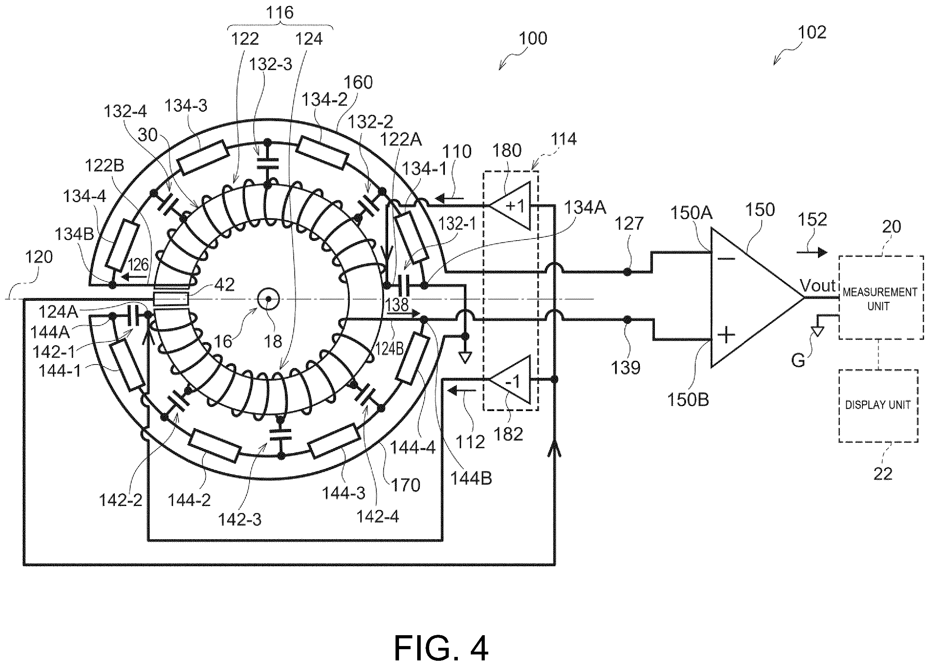

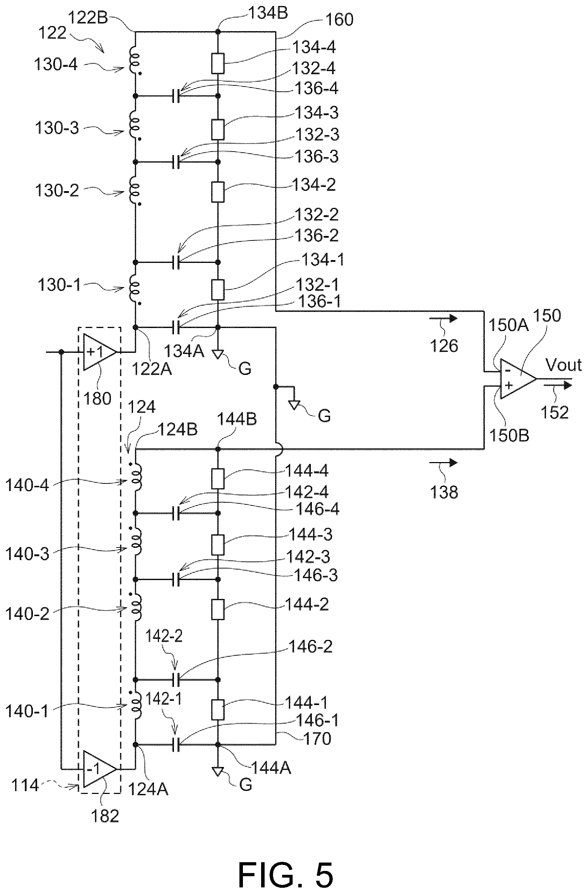

A measurement device 102 including a current sensor 100 according to a second embodiment will be described with reference to FIGS. 4 and 5.

In the second embodiment, the same or equivalent portions as those in the first embodiment are denoted by the same reference numerals as those in the first embodiment and descriptions thereof are omitted, and portions different from those in the first embodiment will be described. The measurement device 102 according to the second embodiment is different from the measurement device 12 of the first embodiment in the configuration of the current sensor 100 of the zero flux type.

FIG. 4 is a schematic view illustrating the measurement device 102 including the current sensor 100 according to the second embodiment. FIG. 5 illustrates an equivalent circuit of the current sensor 100 according to the second embodiment.

As illustrated in FIG. 4, the current sensor 100 includes the annular magnetic core 30, and a feedback circuit 114 that outputs a first negative feedback current 110 and a second negative feedback current 112 for canceling out a magnetic flux generated in the magnetic core 30 based on the measurement current 18 flowing through the measurement object 16. The current sensor 100 includes a winding 116 that is wound around the magnetic core 30, receives the negative feedback currents 110 and 112, detects a magnetic flux flowing through the magnetic core 30, and outputs detection currents 126 and 138 indicating the measurement current 18.

### (Winding)

The winding 116 is composed of a conductive wire. When the magnetic core 30 is bisected by a virtual straight line 120 passing through a center of the magnetic core 30, the winding 116 includes a forward winding 122 wound at one portion with the virtual straight line 120 as a boundary and a reverse winding 124 wound at the other portion with the virtual straight line 120 as a boundary.

The portion of the magnetic core 30 around which the forward winding 122 is wound and the portion of the magnetic core 30 around which the reverse winding 124 is wound face each other. In other words, the portion of the magnetic core 30 around which the forward winding 122 is wound and the portion of the magnetic core 30 around which the reverse winding 124 is wound are line-symmetric with respect to a long-dash dotted line in FIG. 4. The forward winding 122 and the reverse winding 124 are arranged such that one end 122A of the forward winding 122 is close to the other end 124B of the reverse winding 124 and the other end 122B of the forward winding 122 is close to one end 124A of the reverse winding 124.

### [Forward Winding]

The forward winding 122 is wound in a poloidal direction along a toroidal direction at one portion of the magnetic core 30. The first negative feedback current 110 is input from the one end 122A of the forward winding 122. The forward winding 122 detects the magnetic flux flowing through the magnetic core 30 and outputs from the other end 122B a first detection current 126 indicating the measurement current 18. The first detection current 126 detected by the forward winding 122 is mainly composed of a high frequency signal.

As illustrated in FIG. 5, the forward winding 122 includes a plurality of forward winding sections 130-1 to 130-4. An inductance of each of the forward winding sections 130-1 to 130-4 is set in a range of, for example, 1 nH or more and 10 H or less. Forward winding-side resistors 134-1 to 134-4 are connected in parallel to the forward winding sections 130-1 to 130-4 via forward winding-side connection circuits 132-1 to 132-4 constituting a connection circuit.

The forward winding 122 of the second embodiment is divided into four parts by a first forward winding-side connection circuit 132-1 connected to the one end 122A of the forward winding 122 and forward winding-side connection circuit 132-2 to 132-4 connected to positions shifted in the toroidal direction of the forward winding 122.

Specifically, the first forward winding-side connection circuit 132-1 is connected to the one end 122A of the forward winding 122, and a second forward winding-side connection circuit 132-2, a third forward winding-side connection circuit 132-3, and a fourth forward winding-side connection circuit 132-4 are connected to an intermediate portion of the forward winding 122. The first forward winding-side connection circuit 132-1 to the fourth forward winding-side connection circuit 132-4 are arranged in order from the one end 122A to the other end 122B of the forward winding 122.

In the forward winding 122, a first forward winding section 130-1 is formed between a connection position of the first forward winding-side connection circuit 132-1 and a connection position of the second forward winding-side connection circuit 132-2. In the forward winding 122, a second forward winding section 130-2 is formed between a connection position of the second forward winding-side connection circuit 132-2 and a connection position of the third forward winding-side connection circuit 132-3. In the forward winding 122, a third forward winding section 130-3 is formed between a connection position of the third forward winding-side connection circuit 132-3 and a connection position of the fourth forward winding-side connection circuit 132-4. In the forward winding 122, a fourth forward winding section 130-4 is formed between a connection position of the fourth forward winding-side connection circuit 132-4 and the other end 122B of the forward winding 122.

The forward winding-side connection circuits 132-1 to 132-4 include capacitors 136-1 to 136-4. The capacitors 136-1 to 136-4 desirably have the same capacitance value. The capacitance value of each of the capacitors 136-1 to 136-4 is set in a range of, for example, 100 pF or more and 10 µF or less.

### [Reverse Winding]

As illustrated in FIG. 4, the reverse winding 124 is wound around the other portion of the magnetic core 30 in the poloidal direction along a toroidal direction opposite to that of the forward winding 122. The second negative feedback current 112 is input from the one end 124A of the reverse winding 124. The reverse winding 124 detects a magnetic flux flowing through the magnetic core 30 and outputs from the other end 124B a second detection current 138 indicating the measurement current 18. The second detection current 138 detected by the reverse winding 124 is mainly composed of a high frequency signal.

As illustrated in FIG. 5, the reverse winding 124 includes a plurality of reverse winding sections 140-1 to 140-4. An inductance of each of the reverse winding sections 140-1 to 140-4 is set in a range of, for example, 1 nH or more and 10 H or less. Reverse winding-side resistors 144-1 to 144-4 are connected in parallel to the reverse winding sections 140-1 to 140-4 via reverse winding-side connection circuits 142-1 to 142-4 constituting a connection circuit.

The reverse winding 124 of the second embodiment is divided into four parts by a first reverse winding-side connection circuit 142-1 connected to the one end 124A of the reverse winding 124 and reverse winding-side connection circuits 142-2 to 142-4 connected to positions shifted in the toroidal direction of the reverse winding 124.

Specifically, the first reverse winding-side connection circuit 142-1 is connected to the one end 124A of the reverse winding 124, and a second reverse winding-side connection circuit 142-2, a third reverse winding-side connection circuit 142-3, and a fourth reverse winding-side connection circuit 142-4 are connected to an intermediate portion of the reverse winding 124. The first reverse winding-side connection circuit 142-1 to the fourth reverse winding-side connection circuit 142-4 are arranged in order from the one end 124A to the other end 124B of the reverse winding 124.

In the reverse winding 124, a first reverse winding section 140-1 is formed between a connection position of the first reverse winding-side connection circuit 142-1 and a connection position of the second reverse winding-side connection circuit 142-2. In the reverse winding 124, a second reverse winding section 140-2 is formed between a connection position of the second reverse winding-side connection circuit 142-2 and a connection position of the third reverse winding-side connection circuit 142-3. In the reverse winding 124, a third reverse winding section 140-3 is formed between a connection position of the third reverse winding-side connection circuit 142-3 and a connection position of the fourth reverse winding-side connection circuit 142-4. In the reverse winding 124, a fourth reverse winding section 140-4 is formed between a connection position of the fourth reverse winding-side connection circuit 142-4 and the other end 124B of the reverse winding 124.

The reverse winding-side connection circuits 142-1 to 142-4 include capacitors 146-1 to 146-4. The capacitors 146-1 to 146-4 desirably have the same capacitance value. The capacitance value of each of the capacitors 146-1 to 146-4 is set in a range of, for example, 100 pF or more and 10 µF or less.

### (Differential Amplifier)

As illustrated in FIG. 4, the current sensor 10 includes a differential amplifier 150 that amplifies a differential voltage between a voltage (hereinafter, referred to as a voltage 127) of a portion 127 of the wiring through which the first detection current 126 output from the forward winding 122 flows and a voltage (hereinafter, referred to as a voltage 139) of a portion 139 of the wiring through which the second detection current 138 output from the reverse winding 124 flows. The differential amplifier 150 includes, for example, an operational amplifier.

As illustrated in FIG. 4, the differential amplifier 150 outputs the differentially amplified output to the measurement unit 20 as a differential detection current 152. The measurement unit 20 measures the measurement current 18 based on the differential detection current 152. The measurement current 18 measured by the measurement unit 20 is displayed on the display unit 22.

### (Forward Winding-Side Resistor)

A resistance value of each of resistors constituting the forward winding-side resistors 134-1 to 134-4 is set in a range of, for example, 1 Ω or more and 100 Ω or less.

The forward winding-side resistors 134-1 to 134-4 each have a function as a damping resistor that suppresses a resonance caused by the forward winding sections 130-1 to 130-4.

As illustrated in FIG. 5, the forward winding-side resistors 134-1 to 134-4 are connected in series. One end 134A of the forward winding-side resistors 134-1 to 134-4 connected in series is connected to the one end 122A of the forward winding 122 via the first forward winding-side connection circuit 132-1. Further, the one end 134A of the forward winding-side resistors 134-1 to 134-4 connected in series is connected to the reference potential G.

The other end 134B of the forward winding-side resistors 134-1 to 134-4 connected in series is directly connected to the other end 122B of the forward winding 122. Further, the other end 134B of the forward winding-side resistors 134-1 to 134-4 connected in series is connected to a negative terminal 150A of the differential amplifier 150 via a forward winding-side return line 160.

### (Reverse Winding-Side Resistor)

A resistance value of each of resistors constituting the reverse winding-side resistors 144-1 to 144-4 is set in a range of, for example, 1 Ω or more and 100 Ω or less.

The reverse winding-side resistors 144-1 to 144-4 each have a function as a damping resistor that suppresses a resonance caused by the reverse winding sections 140-1 to 140-4.

The reverse winding-side resistors 144-1 to 144-4 are connected in series. One end 144A of the reverse winding-side resistors 144-1 to 144-4 connected in series is connected to the one end 124A of the reverse winding 124 via the first reverse winding-side connection circuit 142-1. Further, the one end 144A of the reverse winding-side resistors 144-1 to 144-4 connected in series is connected to the reference potential G, and is connected to the one end 134A of the forward winding-side resistors 134-1 to 134-4 connected in series via a reverse winding-side return line 170.

The other end 144B of the reverse winding-side resistors 144-1 to 144-4 connected in series is directly connected to the other end 124B of the reverse winding 124. Further, the other end 144B of the reverse winding-side resistors 144-1 to 144-4 connected in series is connected to a positive terminal 150B of the differential amplifier 150.

### (Feedback Circuit)

As illustrated in FIG. 4, the feedback circuit 114 includes a first feedback circuit 180 that generates a first negative feedback current 110 based on a signal input from the magnetic detection element 42 and outputs the first negative feedback current 110 from an output end. The feedback circuit 114 includes a second feedback circuit 182 that generates a second negative feedback current 112 based on the signal input from the magnetic detection element 42 and outputs the second negative feedback current 112 from the output end.

Each of the negative feedback currents 110 and 112 is mainly composed of a current having a frequency from a direct current to a low frequency band. The second negative feedback current 112 is a current obtained by inverting a phase of a waveform of the first negative feedback current 110.

The first feedback circuit 180 outputs the first negative feedback current 110 to the one end 122A of the forward winding 122. The forward winding 122 to which the first negative feedback current 110 is input generates a magnetic flux, and the magnetic flux from the forward winding 122 acts to cancel out the magnetic flux generated in the magnetic core 30 based on the measurement current 18.

The second feedback circuit 182 outputs the second negative feedback current 112 to the one end 124A of the reverse winding 124. The reverse winding 124 to which the second negative feedback current 112 is input generates a magnetic flux, and the magnetic flux from the reverse winding 124 acts to cancel out the magnetic flux generated in the magnetic core 30 based on the measurement current 18.

### (Forward Winding-Side Return Line)

The forward winding-side return line 160 extends from the other end 122B of the forward winding 122. The forward winding-side return line 160 extends along the magnetic core 30 from the other end 122B toward the one end 122A of the forward winding 122.

### (Reverse Winding-Side Return Line)

The reverse winding-side return line 170 extends from the one end 144A of the reverse winding-side resistors 144-1 to 144-4 connected in series. The reverse winding-side return line 170 extends along the magnetic core 30 from the one end 124A to the other end 124B of the reverse winding 124. That is, the reverse winding-side return line 170 and the forward winding-side return line 160 extend in opposite directions along the magnetic core 30.

### (Differential Amplifier)

The current sensor 100 further includes the differential amplifier 150 that amplifies a differential voltage between the voltage 127 corresponding to the first detection current 126 and the voltage 139 corresponding to the second detection current 138.

### (Functions and Effects)

Next, functions and effects of the second embodiment will be described.

In the second embodiment, the same functions and effects as those of the first embodiment can also be exerted for the same portions as those of the first embodiment.

In the current sensor 100 of the second embodiment, the winding 116 includes the forward winding 122 that is wound in the poloidal direction along the toroidal direction at one portion of the opposing portions of the magnetic core 30, receives the first negative feedback current 110 from the one end 122A, detects the magnetic flux flowing through the magnetic core 30, and outputs from the other end 134B the first detection current 126 indicating the measurement current 18. The winding 116 includes the reverse winding 124 that is wound in the poloidal direction along the toroidal direction opposite to that of the forward winding 122 at the other portion of the opposing portions of the magnetic core 30, receives the second negative feedback current 112 from the one end 124A, detects the magnetic flux flowing through the magnetic core 30, and outputs from the other end 144B the second detection current 138 indicating the measurement current 18. The feedback circuit 114 can output, based on the measurement current 18, the first negative feedback current 110 and the second negative feedback current 112 for canceling out the magnetic flux generated in the magnetic core 30.

The resistors include the forward winding-side resistors 134-1 to 134-4 connected in parallel to the forward winding sections 130-1 to 130-4 that constitute the forward winding 122 and are connected in series, and the plurality of reverse winding-side resistors 144-1 to 144-4 connected in parallel to the plurality of reverse winding sections 140-1 to 140-4 that constitute the reverse winding 124 and are connected in series. The connection circuits include the forward winding-side connection circuits 132-1 to 132-4 connected to the forward winding 122, and the reverse winding-side connection circuits 142-1 to 142-4 connected to the reverse winding 124. Each of the forward winding-side connection circuits 132-1 to 132-4 is connected between a connection point between adjacent forward winding-side resistors among the forward winding-side resistors 134-1 to 134-4 and a connection point between adjacent forward winding sections of the forward winding sections 130-1 to 130-4, and between an output end of the feedback circuit 114 that outputs the first negative feedback current 110 and the forward winding-side resistor (134-1) connected to the output end (via the first forward winding-side connection circuit 132-1). Each of the reverse winding-side connection circuits 142-1 to 142-4 is connected between a connection point between adjacent reverse winding-side resistors among the reverse winding-side resistors 144-1 to 144-4 and a connection point between adjacent reverse winding sections of the reverse winding sections 140-1 to 140-4, and between the output end of the feedback circuit 114 that outputs the second negative feedback current 112 and the reverse winding-side resistor (144-1) connected to the output end (via the first reverse winding-side connection circuit 142-1). The current sensor 100 further includes the differential amplifier 150 that amplifies the differential voltage between the first detection current 126 and the second detection current 138.

In the current sensor 100 having this configuration and the measurement device 102, the winding 116 includes the forward winding 122 wound around one portion of the opposing portions of the magnetic core 30 and the reverse winding 124 wound around the other portion of the opposing portions of the magnetic core 30.

For this reason, since a length of the winding 116 can be halved, an influence of a parasitic impedance of the winding 116 at a high frequency can be reduced, and a current can be detected in a wide band ranging from a direct current to a frequency band higher than the predetermined high frequency band.

In the second embodiment, the current sensor 100 further includes the forward winding-side return line 160 extending from the other end 122B of the forward winding 122 and disposed along the magnetic core 30 from the other end 122B toward the one end 122A of the forward winding 122, and the reverse winding-side return line 170 extending from the other end 124B of the reverse winding 124 and disposed along the magnetic core 30 from the other end 124B toward the one end 124A of the reverse winding 124.

In the current sensor 100 having this configuration, the forward winding-side return line 160 disposed along the forward winding 122 and the reverse winding-side return line 170 disposed along the reverse winding 124 are separated.

For this reason, since a length of each of the return lines 160 and 170 can be halved, an influence of a parasitic impedance of each of the return lines 160 and 170 at a high frequency can be reduced, and the current can be detected in the wide band ranging from the direct current to the frequency band higher than the predetermined high frequency band.

Further, in the second embodiment, the differential amplifier 150 is provided that amplifies a differential voltage between the voltage 127 based on the first detection current 126 from the forward winding 122 and the voltage 139 based on the second detection current 138 from the reverse winding 124.

For this reason, since in-phase noise can be reduced, a dynamic range of a measurement value acquired by the current sensor 100 can be expanded, and the frequency characteristics can be improved.

### <Third Embodiment>

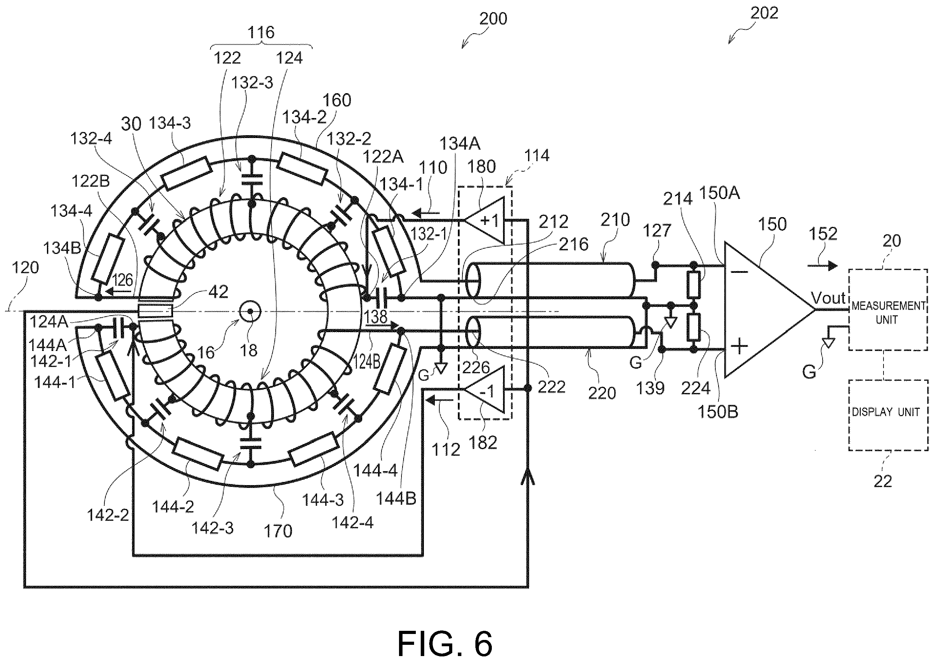

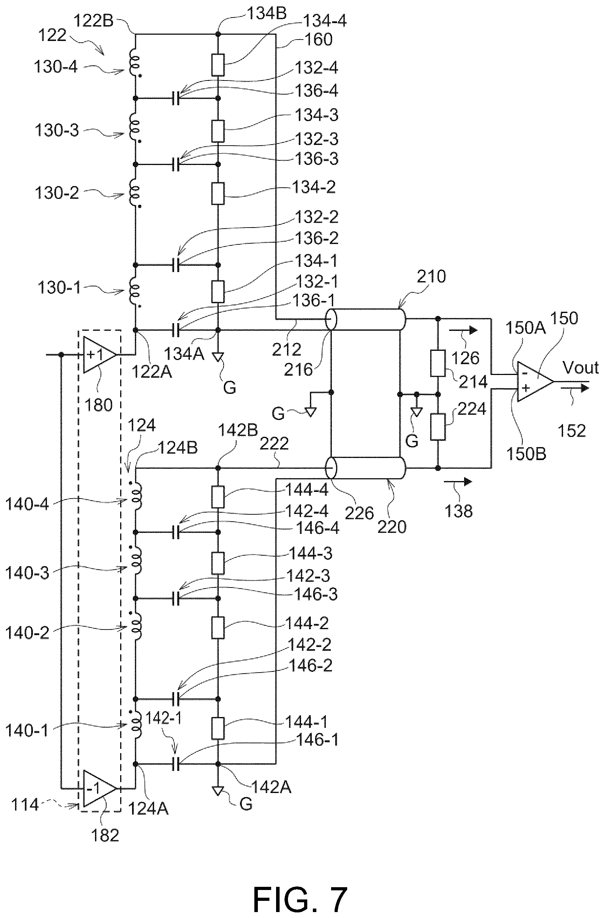

A measurement device 202 including a current sensor 200 according to a third embodiment will be described with reference to FIGS. 6 and 7.

In the third embodiment, the same or equivalent portions as those in the second embodiment are denoted by the same reference numerals as those in the second embodiment and descriptions thereof are omitted, and portions different from those in the second embodiment will be described. The measurement device 202 (see FIG. 6) according to the third embodiment is different from the measurement device 102 (see FIG. 4) of the second embodiment in a part of the configuration of the current sensor 200 of the zero flux type.

FIG. 6 is a schematic view illustrating the measurement device 202 including the current sensor 200 according to the third embodiment. FIG. 7 illustrates an equivalent circuit of the current sensor 200 according to the third embodiment.

As illustrated in FIGS. 6 and 7, the forward winding-side return line 160 extending from the forward winding 122 is connected to the negative terminal 150A of the differential amplifier 150 via an inner conductor 212 constituting a core wire of a first coaxial cable 210. The inner conductor 212 of the first coaxial cable 210 is connected to the reference potential G via a first resistor 214.

In the forward winding 122, the one end 134A of the forward winding-side resistors 134-1 to 134-4 connected in series is connected to an outer conductor 216 constituting a shield portion of the first coaxial cable 210. The outer conductor 216 of the first coaxial cable 210 is connected to the reference potential G at both ends of the first coaxial cable 210.

The other end 124B of the reverse winding 124 is connected to the positive terminal 150B of the differential amplifier 150 via an inner conductor 222 constituting a core wire of a second coaxial cable 220. The inner conductor 222 constituting the core wire of the second coaxial cable 220 is connected to the reference potential G via a second resistor 224.

In the reverse winding 124, the reverse winding-side return line 170 extending from the one end 144A of the reverse winding-side resistors 144-1 to 144-4 connected in series is connected to the outer conductor 226 constituting a shield portion of the second coaxial cable 220. The outer conductor 226 of the second coaxial cable 220 is connected to the reference potential G at both ends of the second coaxial cable 220.

A characteristic impedance of the first coaxial cable 210 and a characteristic impedance of the second coaxial cable 220 are 50 Ω. A resistance value of the first resistor 214 and a resistance value of the second resistor 224 are 50 Ω.

Accordingly, the impedance of each of the coaxial cables 210 and 220 and the impedance of each of the resistors 214 and 224 coincide with each other to achieve impedance matching, and transmission loss and reflection loss are suppressed.

A total impedance of the forward winding-side resistors 134-1 to 134-4 and a total impedance of the reverse winding-side resistors 144-1 to 144-4 are preferably 50 Ω.

### (Functions and Effects)

Next, functions and effects of the third embodiment will be described.

In the third embodiment, the same portions as those of the first embodiment and the second embodiment have the same functions and effects as those of the first embodiment and the second embodiment.

In the current sensor 200 having this configuration and the measurement device 202, the outer conductor 216 of the first coaxial cable 210 is connected to the reference potential G at both ends of the first coaxial cable 210, and the outer conductor 226 of the second coaxial cable 220 is connected to the reference potential G at both ends of the second coaxial cable 220.

For this reason, since voltages of the outer conductors 216 and 226 of the coaxial cables 210 and 220 are stabilized over the entire range, the fluctuation of the reference potential G near the differential amplifier 150 is suppressed, dynamic ranges of measurement values acquired by the current sensor 200 and the measurement device 202 can be expanded, and the frequency characteristics can be improved.

The forward winding-side return line 160 extending from the forward winding 122 is connected to the negative terminal 150A of the differential amplifier 150 via the inner conductor 212 constituting the core wire of the first coaxial cable 210. The inner conductor 212 of the first coaxial cable 210 is connected to the reference potential G via the first resistor 214. The other end 124B of the reverse winding 124 is connected to the positive terminal 150B of the differential amplifier 150 via the inner conductor 222 constituting the core wire of the second coaxial cable 220. The inner conductor 222 constituting the core wire of the second coaxial cable 220 is connected to the reference potential G via the second resistor 224. A connection point between the first resistor 214 and the second resistor 224 is connected to the reference potential G, and the first resistor 214 and the second resistor 224 have the same resistance value.

For this reason, since a midpoint between the first resistor 214 and the second resistor 224 connected in series is connected to the reference potential G, the fluctuation of the differential detection current 152 is suppressed, the dynamic range of the measurement value can be expanded, and the frequency characteristics can be improved.

Further, a combined resistance value of the forward winding-side resistors 134-1 to 134-4 connected in series and the resistance value of the first resistor 214 are set to be the same as the characteristic impedance of the coaxial cable 210. Similarly, a combined resistance value of the reverse winding-side resistors 144-1 to 144-4 connected in series and the resistance value of the second resistor 224 are set to be the same as the characteristic impedance of the coaxial cable 220.

For this reason, the combined resistance value of the resistors 134-1 to 134-4 and the impedance of the coaxial cable 210 can be matched with the resistance value of the first resistor 214, and the combined resistance value of the resistors 144-1 to 144-4 and the impedance of the coaxial cable 220 can be matched with the resistance value of the second resistor 224. Accordingly, it is possible to prevent a signal from being reflected and becoming noise or an output from decreasing.

### <Fourth Embodiment>

A detection device including a current sensor 300 according to a fourth embodiment will be described with reference to FIGS. 8 to 10.

In the fourth embodiment, the same or equivalent portions as those in the third embodiment are denoted by the same reference numerals as those in the third embodiment and descriptions thereof are omitted, and portions different from those in the third embodiment will be described. A measurement device according to the fourth embodiment is different from the measurement device 202 (see FIG. 6) of the third embodiment in the configurations of the forward winding-side connection circuits 132-1 to 132-4 and the reverse winding-side connection circuits 142-1 to 142-4 (see FIG. 7) of the current sensor 300 of the zero flux type (see FIG. 8).

FIG. 8 illustrates a part of an equivalent circuit of the current sensor 300 according to the fourth embodiment. FIG. 9 illustrates a connection circuit according to the fourth embodiment.

FIG. 8 illustrates only forward winding-side connection circuits 310-1 to 310-4 corresponding to the forward winding-side connection circuits 132-1 to 132-4 among the forward winding-side connection circuits 132-1 to 132-4 and the reverse winding-side connection circuits 142-1 to 142-4 of the third embodiment illustrated in FIG. 7.

The reverse winding-side connection circuits 142-1 to 142-4 (see FIG. 7) of the current sensor 300 according to the fourth embodiment are configured similarly to the forward winding-side connection circuits 310-1 to 310-4. In FIG. 9, only a first forward winding-side connection circuit 310-1 is illustrated, but other forward winding-side connection circuits 310-2 to 310-4 and the reverse winding-side connection circuits are configured similarly to the first forward winding-side connection circuit 310-1.

As illustrated in FIG. 8, each of the forward winding-side connection circuits 310-1 to 310-4 includes a first circuit 320 and a second circuit 322 connected in parallel.

In addition to the first circuit 320 and the second circuit 322, another CR series circuit may be connected in parallel.

As illustrated in FIG. 9, the first circuit 320 includes a first capacitor 330 and a first resistor 332 which are connected in series. A capacitance value of the first capacitor 330 is, for example, 100 nF. A resistance value of the first resistor 332 is, for example, 10 Ω.

The second circuit 322 includes a second capacitor 340 and a second resistor 342 which are connected in series. A capacitance value of the second capacitor 340 is, for example, 2.2 µF. A resistance value of the second resistor 342 is, for example, 100 Ω.

In this way, the first capacitor 330 constituting the first circuit 320 and the second capacitor 340 constituting the second circuit 322 have different capacitance values.

It is desirable to set an impedance of the second circuit 322 to be ten times or more an impedance of the first circuit 320. Specifically, it is desirable to set the capacitance value of the second capacitor 340 of the second circuit 322 to be ten times or more the capacitance value of the first capacitor 330 of the first circuit 320. It is desirable to set the resistance value of the second resistor 342 of the second circuit 322 to be ten times or more the resistance value of the first resistor 332 of the first circuit 320.

### (Functions and Effects)

Next, functions and effects of the fourth embodiment will be described.

In the fourth embodiment, the same portions as those of the first embodiment to the third embodiment have the same functions and effects as those of the first embodiment to the third embodiment.

In the current sensor 300 having this configuration and the measurement device including the current sensor 300, each of the forward winding-side connection circuits 310-1 to 310-4 and each of the reverse winding-side connection circuits include the capacitors 330 and 340 and the resistors 332 and 342, which are connected in series.

With this configuration, the resonance that may occur at a resonance frequency corresponding to the capacitance value of each of the capacitors 330 and 340 can be attenuated by each of the resistors 332 and 342 connected in series to each of the capacitors 330 and 340. Accordingly, the frequency characteristics can be improved.

In the current sensor 300 of the fourth embodiment, each of the forward winding-side connection circuits 310-1 to 310-4 and each of the reverse winding-side connection circuits include the first circuit 320 and the second circuit 322 connected in parallel.

The first circuit 320 includes the first capacitor 330 and the first resistor 332 which are connected in series. The second circuit 322 includes the second capacitor 340 and the second resistor 342 which are connected in series. The first capacitor 330 and the second capacitor 340 have different capacitance values.

With this configuration, a frequency at which the resonance is attenuated in the first circuit 320 can be made different from a frequency at which the resonance is attenuated in the second circuit 322.

By adjusting the capacitance values of the first capacitor 330 and the second capacitor 340, it is possible to suppress the resonance in a plurality of frequency bands in the measurement range.

In the second embodiment and the third embodiment, LC resonance may be caused by the winding sections of the winding, the resistors, the capacitor of the respective connection circuits.

Specifically, the winding sections indicate the forward winding sections 130-1 to 130-4 and the reverse winding sections 140-1 to 140-4. The resistors indicate the resistors 134-1 to 134-4 and 144-1 to 144-4. The capacitors of the respective connection circuits indicate the capacitors 136-1 to 136-4 and 146-1 to 146-4 of the connection circuits 132-1 to 132-4 and 142-1 to 142-4. Further, the LC resonance may be caused by various inductance components such as a winding, a leakage flux, and an external magnetic flux.

Each of the forward winding-side connection circuits 310-1 to 310-4 and each of the reverse winding-side connection circuits 142-1 to 142-4 of the current sensor 300 of the fourth embodiment include the first circuit 320 and the second circuit 322 connected in parallel. Each of the circuits 320 and 322 can suppress potential LC resonance.

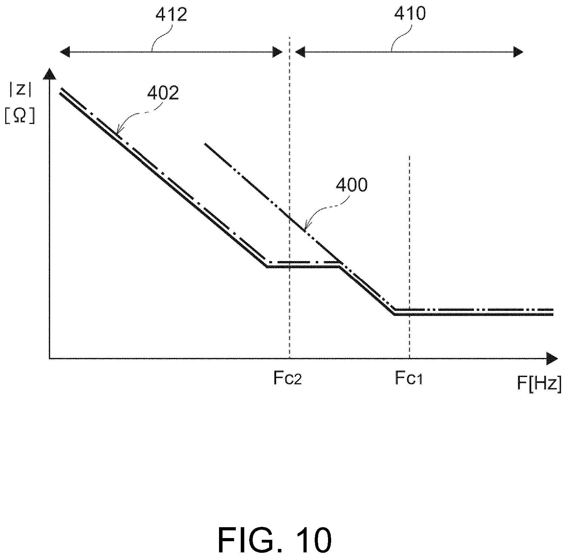

FIG. 10 illustrates a relationship between a frequency and an impedance in each of the connection circuits 310-1 to 310-4 (see FIG. 8) according to the fourth embodiment.

A long-dash double-dotted line in FIG. 10 indicates a first frequency characteristic 400 of the first circuit 320, indicating a relationship between a frequency and an absolute value of an impedance. A long-dash dotted line in FIG. 10 indicates a second frequency characteristic 402 of the second circuit 322, indicating a relationship between a frequency and an absolute value of an impedance.

In the first circuit 320, an absolute value of an impedance of the first circuit 320 decreases at a first cutoff frequency Fc1 determined by the capacitance value of the first capacitor 330.

In the second circuit 322, an absolute value of an impedance of the second circuit 322 decreases at a second cutoff frequency Fc2 determined by the capacitance value of the second capacitor 340.

Accordingly, the resonance that may occur due to the capacitance values of the forward winding-side connection circuits 310-1 to 310-4 and the reverse winding-side connection circuits can be suppressed at the first cutoff frequency Fc1 in a high frequency band 410. In addition, the resonance that may occur due to the capacitance values of the forward winding-side connection circuits 310-1 to 310-4 and the reverse winding-side connection circuits can be suppressed at the second cutoff frequency Fc2 in a low frequency band 412.

Although the embodiments have been described above, the above embodiments merely exemplify some of application examples of the present invention and do not intend to limit the technical scope of the present invention to the specific configurations of the above embodiments.

In the above embodiments, the case where each of the windings 40, 116, 122, and 124 is divided into eight or four parts has been described, but each of the windings 40, 116, 122, and 124 may be divided into ten or forty parts, for example.

Further, in the above embodiments, the magnetic core 30 is configured by an annular core having a gap for sandwiching the magnetic detection element 42, but for example, the magnetic core 30 may be configured by an annular core having no gap, and the flux gate may be arranged side-by-side with the magnetic core 30.

The present application claims priority based on Japanese Patent Application No. 2022-202523 filed to the Japan Patent Office on December 19, 2022 and priority based on Japanese Patent Application No. 2023-197583 filed to the Japan Patent Office on November 21, 2023, and all contents of these applications are incorporated herein by reference.

### DESCRIPTION OF REFERENCE SIGNS

10, 10A, 100, 200, 300 current sensor
12, 12A, 102, 202 measurement device
14 detection current
16 measurement object
18 measurement current
20 measurement unit
30 magnetic core
32 negative feedback current
34 feedback circuit
40 winding
40A one end
40B the other end
42 magnetic detection element
50-1~50-8 first winding section to eighth winding section
60-1~60-8 capacitor
62-1~62-8 first connection circuit to eighth connection circuit
64-1~64-8 resistor
80 return line
110 first negative feedback current
112 second negative feedback current
112A one end
112B the other end
114 feedback circuit
116 winding
116A one end
116B the other end
122 forward winding
122A one end
122B the other end
124 reverse winding
124A one end
124B the other end
126 first detection current
130-1~130-4 first forward winding section to fourth forward winding section
132-1~132-4 first forward winding-side connection circuit to fourth forward winding-side connection circuit
134-1~134-4 forward winding-side resistor
134A one end
134B the other end
136-1~136-4 capacitor
138 second detection current
140-1~140-4 first reverse winding section to fourth reverse winding section
142-1~142-4 first reverse winding-side connection circuit to fourth reverse winding-side connection circuit
144-1~144-4 reverse winding-side resistor
144A one end
144B the other end
146-1~146-4 capacitor
150 differential amplifier
160 forward winding-side return line
170 reverse winding-side return line
180 first feedback circuit
182 second feedback circuit
310-1~310-4 forward winding-side connection circuit
320 first circuit
322 second circuit
330 first capacitor
332 first resistor
340 second capacitor
342 second resistor

## Claims

1. A current sensor of a zero flux type, comprising:
a magnetic core configured to surround a measurement object through which a measurement current flows;
a magnetic detection element incorporated in the magnetic core and configured to detect a magnetic flux generated in the magnetic core;
a feedback circuit configured to output, based on a signal input from the magnetic detection element, a negative feedback current for canceling out the magnetic flux generated in the magnetic core by the measurement current;
a winding wound around the magnetic core and configured to receive the negative feedback current from one end of the winding, detect a magnetic flux flowing through the magnetic core, and output from the other end of the winding a detection current indicating the measurement current;
a plurality of connection circuits configured to block components from a direct current to a low frequency band; and
a plurality of resistors connected in parallel to a plurality of winding sections that constitute the winding and are connected in series, wherein
each of the plurality of connection circuits is connected between a connection point between adjacent resistors among the plurality of resistors and a connection point between adjacent winding sections, and between an output end of the feedback circuit and a resistor connected to the output end.

2. The current sensor according to claim 1, further comprising:
a return line extending from the other end of the winding and disposed along the magnetic core from the other end of the winding toward the one end of the winding.

3. The current sensor according to claim 1 or claim 2, wherein
the connection circuit includes a capacitor and a resistor which are connected in series.

4. The current sensor according to claim 1 or claim 2, wherein
the connection circuit includes a parallel connection circuit including a first circuit in which a first capacitor and a first resistor are connected in series and a second circuit in which a second capacitor and a second resistor are connected in series, and
the first capacitor and the second capacitor have different capacitance values.

5. The current sensor according to claim 1, wherein
the winding includes a forward winding that is wound in a poloidal direction along a toroidal direction at one portion of opposing portions of the magnetic core, receives a first negative feedback current from one end of the forward winding, detects a magnetic flux flowing through the magnetic core, and outputs from the other end of the forward winding a first detection current indicating the measurement current, and a reverse winding that is wound in the poloidal direction along a toroidal direction opposite to that of the forward winding at the other portion of the opposing portions of the magnetic core, receives a second negative feedback current from one end of the reverse winding, detects a magnetic flux flowing through the magnetic core, and outputs from the other end of the reverse winding a second detection current indicating the measurement current,
the feedback circuit is configured to output, based on the measurement current, the first negative feedback current and the second negative feedback current for canceling out the magnetic flux generated in the magnetic core,
the resistors include a plurality of forward winding-side resistors connected in parallel to a plurality of forward winding sections that constitute the forward winding and are connected in series, and a plurality of reverse winding-side resistors connected in parallel to a plurality of reverse winding sections that constitute the reverse winding and are connected in series,
the connection circuits include each of a plurality of forward winding-side connection circuits connected to the forward winding and each of a plurality of reverse winding-side connection circuits connected to the reverse winding,
each of the plurality of forward winding-side connection circuits is connected between a connection point between adjacent forward winding-side resistors among the plurality of forward winding-side resistors and a connection point between adjacent forward winding sections, and between an output end of the feedback circuit configured to output the first negative feedback current and a forward winding-side resistor connected to the output end,
each of the plurality of reverse winding-side connection circuits is connected between a connection point between adjacent reverse winding-side resistors among the plurality of reverse winding-side resistors and a connection point between adjacent reverse winding sections, and between an output end of the feedback circuit configured to output the second negative feedback current and a reverse winding-side resistor connected to the output end, and
the current sensor further comprises a differential amplifier configured to amplify a differential voltage between the first detection current and the second detection current.

6. The current sensor according to claim 5, further comprising:
a forward winding-side return line extending from the other end of the forward winding and disposed along the magnetic core from the other end of the forward winding to the one end of the forward winding; and
a reverse winding-side return line extending from the other end of the reverse winding and disposed along the magnetic core from the other end of the reverse winding to the one end of the reverse winding.

7. The current sensor according to claim 5 or claim 6, wherein
each of the forward winding-side connection circuit and the reverse winding-side connection circuit includes a capacitor and a resistor which are connected in series.

8. The current sensor according to claim 5 or claim 6, wherein
each of the forward winding-side connection circuit and the reverse winding-side connection circuit includes a parallel connection circuit including a first circuit in which a first capacitor and a first resistor are connected in series and a second circuit in which a second capacitor and a second resistor are connected in series, and
the first capacitor and the second capacitor have different capacitance values.

9. A measurement device comprising:
the current sensor according to any one of claims 1 to 8; and
a measurement unit configured to measure the measurement current based on the detection current output from the current sensor.
